(19) Europäisches Patentamt
European Patent Office
Office européen des brevets

(11) **EP 4 009 349 A1**

(12) **EUROPEAN PATENT APPLICATION**

(43) Date of publication:
**08.06.2022 Bulletin 2022/23**

(21) Application number: **20211715.6**

(22) Date of filing: **03.12.2020**

(51) International Patent Classification (IPC):
***H01J 37/304*** (2006.01)

(52) Cooperative Patent Classification (CPC):
**H01J 37/304;** H01J 2237/244; H01J 2237/2817;
H01J 2237/2826

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **SLOT, Erwin
  5500 AH Veldhoven (NL)**
• **MANGNUS, Albertus Victor Gerardus
  5500 AH Veldhoven (NL)**

(74) Representative: **ASML Netherlands B.V.
Corporate Intellectual Property
P.O. Box 324
5500 AH Veldhoven (NL)**

(54) **CHARGED PARTICLE TOOL, CALIBRATION METHOD, INSPECTION METHOD**

(57)    A charged-particle tool configured to generate a plurality of sub-beams from a beam of charged particles and direct the sub-beams downbeam toward a sample 600 position, the tool charged-particle tool comprising;
at least three charged-particle-optical components 201,111,235,234;
a detector module 240 configured to generate a detection signal in response to charged particles that propagate upbeam from the direction of the sample position; and
a controller configured to operate the tool in a calibration mode; wherein:
the charged-particle-optical components include: a charged-particle source 201 configured to emit a beam of charged particles and a beam generator 111 configured to generate the sub-beams; and
the detection signal contains information about alignment of at least two of the charged-particle-optical components.

## Fig. 14

**Description**

FIELD

The embodiments provided herein generally relate to a charged particle assessment tools and inspection methods, and particularly to charged particle assessment tools and inspection methods that use multiple sub-beams of charged particles.

BACKGROUND

When manufacturing semiconductor integrated circuit (IC) chips, undesired pattern defects often occur on a substrate (i.e. wafer) or a mask during the fabrication processes, thereby reducing the yield. Such defects can occur as a consequence of, for example, optical effects and incidental particles as well as in subsequent processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

There is a general need to improve the throughput and other characteristics of a charged particle inspection apparatus. In particular, the various elements of an electron optical column must be calibrated. This is a time consuming process that needs to be improved.

SUMMARY

The embodiments provided herein disclose a charged particle beam inspection apparatus.

According to a first aspect of the invention, there is provided a charged-particle tool configured to generate a plurality of sub-beams from a beam of charged particles and direct the sub-beams downbeam toward a sample position, the tool charged-particle tool comprising;

at least three charged-particle-optical components;

a detector module configured to generate a detection signal in response to charged particles that propagate upbeam from the direction of the sample position; and

a controller configured to operate the tool in a calibration mode; wherein:

the charged-particle-optical components include: a charged-particle source configured to emit a beam of charged particles and a beam generator configured to generate the sub-beams; and
the detection signal contains information about alignment of at least two of the charged-particle-optical components.

According to a second aspect of the invention, there is provided a calibration method comprising:

dividing a beam of charged particles from a charged particle source into a plurality of sub-beams;
projecting the plurality of charged-particle beams toward a calibration object; and
detecting returning electrons using a detector module and obtaining an alignment calibration value therefrom.

According to a third aspect of the invention, there is provided a charged-particle tool comprising:

a charged-particle source configured to generate a beam of charged particles;
a controller configured to operate the tool in a calibration mode; and
an electron optical column configured to generate a plurality of sub-beams from the beam of charged particles and direct the sub-beams downbeam toward a sample position, the column comprising an objective lens arrangement comprising

a beam generator to generate the plurality of sub-beams,
a beam shaper configured to define from incoming sub-beams the sub-beams that are projected towards the sample position, and
a detector module configured to generate a detection signal in response to incidental charged particles that propagate upbeam from the direction of the sample position, the beam generator and the beam shaper having pre-defined alignment; and
wherein the detection signal contains information about alignment of the charged-particle source with respect the pre-aligned beam generator and beam shaper.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.
FIG. 2 is a schematic diagram illustrating an exemplary multi-beam apparatus that is part of the exemplary charged particle beam inspection apparatus of FIG. 1.
FIG. 3 is a schematic diagram of exemplary multi-beam apparatus according to an embodiment.
FIG. 4 is a schematic cross-sectional view of an objective lens of an inspection apparatus according to an embodiment.
FIG. 5 is a bottom view of the objective lens of FIG. 4.
FIG. 6 is a bottom view of a modification of the objective lens of FIG. 4.
FIG. 7 is an enlarged schematic cross-sectional view of a detector incorporated in the objective lens of FIG. 4.
FIG. 8 is a schematic side view of an array of correctors.
FIG. 9 is a schematic plan view of an array of correctors.
FIG. 10 is a schematic side view of a two-layer corrector array.
FIG. 11 is a schematic diagram of exemplary multi-beam apparatus according to an embodiment.
FIGs. 12 and 13 are schematic diagrams showing an exemplary multi-beam apparatus according to an embodiment operating in scan and calibration modes.
FIGs. 14 and 15 are schematic diagrams explaining electron trajectories.
FIGs. 16 to 20 are schematic diagrams of various detector arrangements usable in embodiments of the invention.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises an scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

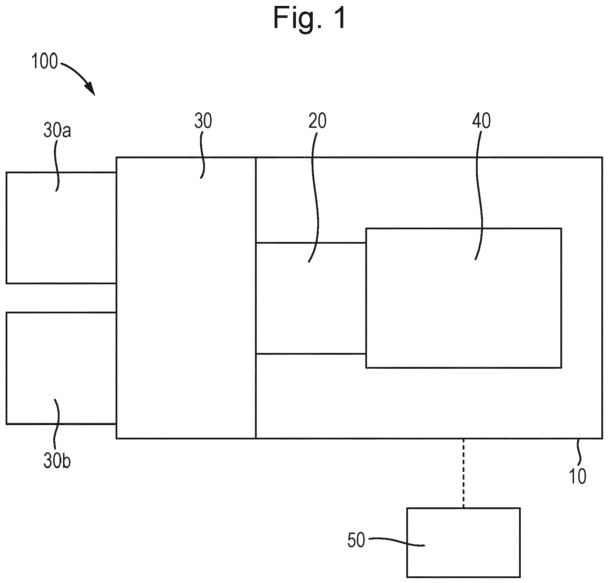

Reference is now made to **FIG. 1,** which is a schematic diagram illustrating an exemplary charged particle beam inspection apparatus 100. The charged particle beam inspection apparatus 100 of **FIG. 1** includes a main chamber 10, a load lock chamber 20, an electron beam tool 40, an equipment front end module (EFEM) 30 and a controller 50. Electron beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be inspected. An electron beam tool 40 may comprise a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

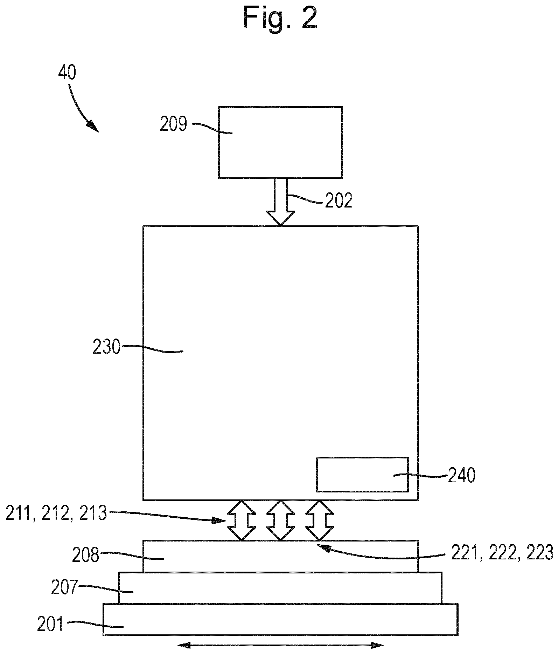

Reference is now made to **FIG. 2,** which is a schematic diagram illustrating an exemplary electron beam tool 40 including a multi-beam inspection tool that is part of the exemplary charged particle beam inspection apparatus 100 of **FIG. 1.** Multi-beam electron beam tool 40 (also referred to herein as apparatus 40) comprises an electron source 201, a projection apparatus 230, a motorized stage 209, and a sample holder 207. The electron source 201 and projection apparatus 230 may together be referred to as an illumination apparatus. The sample holder 207 is supported by motorized stage 209 so as to hold a sample 208 (e.g., a substrate or a mask) for inspection. Multi-beam electron beam tool 40 further comprises an electron detection device 240.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202.

Projection apparatus 230 is configured to convert primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

Controller 50 may be connected to various parts of charged particle beam inspection apparatus 100 of **FIG. 1,** such as electron source 201, electron detection device 240, projection apparatus 230, and motorized stage 209. Controller 50 may perform various image and signal processing functions. Controller 50 may also generate various control signals to govern operations of the charged particle beam inspection apparatus, including the charged particle multi-beam apparatus.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, electrons are generated from the sample 208 which include secondary electrons and backscattered electrons. The secondary electrons typically have electron energy $\leq 50$ eV and backscattered electrons typically have electron energy between 50 eV and the landing energy of primary sub-beams 211, 212, and 213.

Electron detection device 240 is configured to detect secondary electrons and/or backscattered electrons and to generate corresponding signals which are sent to controller 50 or a signal processing system (not shown), e.g. to construct images of the corresponding scanned areas of sample 208. Desirably, electron detection device is incorporated into the projection apparatus. Alternatively it may be separate therefrom, with a secondary electron-optical column being provided to direct secondary electrons and/or backscattered electrons to the electron detection device.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

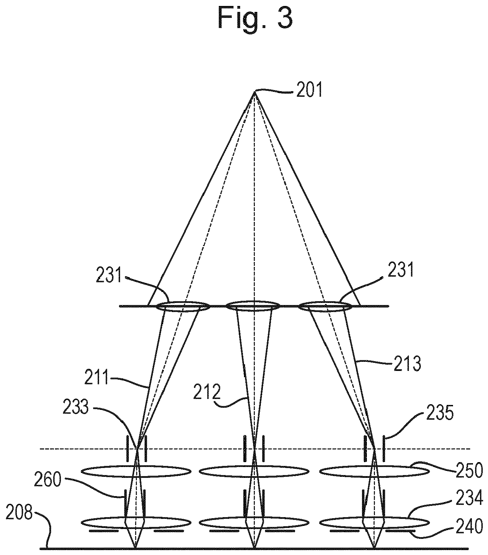

**FIG. 3** is a schematic diagram of an assessment tool comprising an electron source 201 and an electron optical column. (In another arrangement the source is part of the electron-optical column). The electron optical column comprises a plurality of electron optical elements. An electron optical element is any element that affects (e.g. directs, shapes or focuses) an electron beam and may use electric and/or magnetic fields. Electron source 201 directs electrons toward an array of condenser lenses 231 forming part of the electron optical column. The electron source is desirably a high brightness thermal field emitter with a good compromise between brightness and total emission current. There may be many tens, many hundreds or many thousands of condenser lenses 231. Condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array therefore functions as a beam divider, beam splitter, beam generator or beam separator. The condenser lens array may take the form of at least two plates, acting as electrodes, with an aperture in each plate aligned with each other and corresponding to the location of a sub-beam. At least two of the plates are maintained during operation at different potentials to achieve the desired lensing effect. The plates therefore have an array of apertures, each aperture corresponding to the path of a sub-beam. The plate positioned most up beam is the beam separator and may referred to as a beam limiting aperture. In a different arrangement the beam separator may be part of or associated with the condenser lens array, with a separate function form lensing the sub-beams.

In an arrangement the condenser lens array is formed of three plate arrays in which charged particles have the same energy as they enter and leave each lens, which arrangement may be referred to as an Einzel lens. The beam energy is the same on entering as leaving the Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective sub-beam 211, 212, 213 which is focused at a respective intermediate focus 233. The sub-beams diverge with respect to each other. At the intermediate focuses 233 are deflectors 235. The deflectors 235 are positioned in the beamlet paths at, or at least around, the position of the corresponding intermediate focusses 233 or focus points (i.e. points of focus). The deflectors are positioned in the beamlet paths at the intermediate image plane of the associated beamlet, i.e. at its focus or focus point. The deflectors 235 are configured to operate on the respective beamlets 211, 212, 213. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample). Deflectors 235 may also be referred to as collimators or collimator deflectors. The deflectors 235 in effect collimate the paths of the beamlets so that before the deflectors, the beamlets paths with respect to each other are diverging. Down beam of the deflectors the beamlet paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array.

Below (i.e. downbeam or further from source 201) deflectors 235 there is a control lens array 250 comprising a control lens 251 for each sub-beam 211, 21, 213. Control lens array 250 may comprise at least two, for example three, plate electrode arrays connected to respective potential sources. A function of control lens array 250 is optimize the beam opening angle with respect to the demagnification of the beam and/or to control the beam energy delivered to objective lenses 234, each of which directs a respective sub-beam 211, 212, 213 onto the sample 208. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. Note that the reference to demagnification and opening angle is intended to refer to variation of the same parameter. In an ideal arrangement the product of demagnification and the corresponding opening angle is constant over a range of values.

The objective lenses 234 are arranged in an objective lens array. Objective lenses 234 can be configured to demagnify the electron beam by a factor greater than 10, desirably in the range of 50 to 100 or more. The objective lenses 234 may be Einzel lenses. At least the chromatic aberrations generated in a beam by a condenser lens and the corresponding downbeam objective lens may mutually cancel.

An electron detection device 240 is provided between the objective lenses 234 and the sample 208 to detect secondary and/or backscattered electrons emitted from the sample 208. An exemplary construction of the electron detection system is described below.

Optionally an array of scan deflectors 260 is provided between the control lens array 250 and the array of objective lenses 234. The array of scan deflectors 260 comprises a scan deflector 261 for each sub-beam 211, 212, 213. Each scan deflector is configured to deflect a respective sub-beam 211, 212, 213 in one or two directions so as to scan the sub beam across the sample 208 in one or two directions.

The system of **FIG. 3** can be configured to control the landing energy of the electrons on the sample. The landing energy can be selected to increase emission and detection of secondary electrons dependent on the nature of the sample being assessed. A controller provided to control the objective lenses 234 may be configured to control the landing energy by varying the potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. A controller may be configured to control the landing energy to any desired value within a predetermined range or to a desired one of a plurality of predetermined values. In an embodiment, the landing energy can be controlled to desired value in the range of from 1000 eV to 5000 eV.

Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can also be referred to as a refocus lens as it can function to correct the focus position in view of changes in the landing energy. The use of the control lens array enables the objective lens array to be operated at its optimal electric field strength. Details of electrode structures and potentials that can be used to control landing energy are disclosed in EPA 20158804.3, which document is incorporated herein by reference.

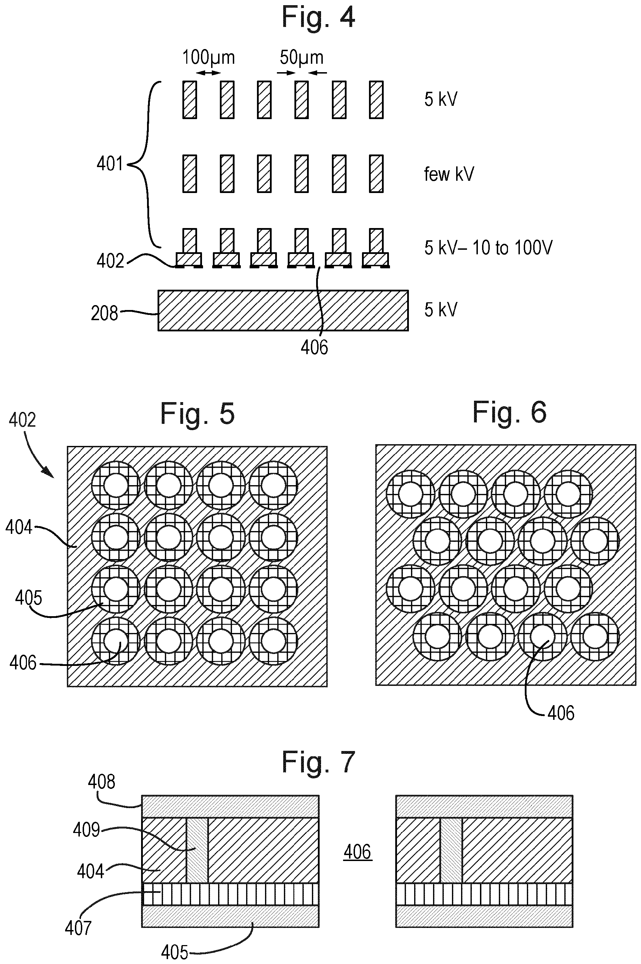

The landing energy of the electrons may be controlled in the system of Figure 4 because any off-axis aberrations generated in the beamlet path are generated in, or at least mainly in, the condenser lenses 231. The objective lenses 234 of the system shown in **FIG. 3** need not be Einzel lenses. This is because, as the beams are collimated, off-axis aberrations would not be generated in the objective lenses. The off-axis aberrations can be controlled better in the condenser lenses than in the objective lenses 234. By making the condenser lenses 231 substantially thinner the contributions of the condenser lenses to the off-axis aberrations, specifically the chromatic off-axis aberrations, may be minimized. The thickness of the condenser lens 231 may be varied to tune the chromatic off-axis contribution balancing other contributions of the chromatic aberrations in the respective beamlet paths. Thus the objective lenses 234 may have two or more electrodes. The beam energy on entering an objective lens can be different from its energy leaving the objective lens, for example to provide a decelerating objective lens. Further in using two electrodes as few electrodes are used as possible, enabling the lens array to take a smaller volume.

In some embodiments, the charged particle assessment tool further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane or focus points) comprise deflectors to correct for the source 201 appearing to be at different positions for different beams. Correctors can be used to correct macroscopic aberrations resulting from the source that prevent a good alignment between each sub-beam and a corresponding objective lens. In some circumstances it is desirable to position the correctors as far upbeam as possible. In this way, a small angular correction can effect a large displacement at the sample so that weaker correctors can be used. Desirably the correctors are positioned to minimize introduction of additional aberrations.

The aberration correctors may correct other aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses 231 are vertically close or coincident with the beam apertures. That is, correction by the corrector of any angular error will require a smaller positional shift than if the corrector is positioned further downbeam. Correcting such aberrations further downbeam such as at the intermediate foci may be impacted by misalignment between the sub-beams 211, 212, 213 and the correctors. A challenge with positioning correctors at or near the condenser lenses 231, however, is that the sub-beams each have relatively large sectional areas and relatively small pitch at this location, relative to locations further downbeam. In situations with volume restrictions, the corrector array or additional corrector arrays may be located away from these preferred locations, such as between the condenser lens array and the intermediate focus positions.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 214 over the sample 208. In an embodiment, the scanning deflectors described in US 2010/0276606, which document is hereby incorporated by reference in its entirety, may be used.

The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. There may be an aberration corrector of this design for each beamlet, i.e. an individual beamlet corrector. The individual beamlet correctors may be in an array across the multi-beam, which may be referred to as a corrector array.

In an embodiment the objective lens array referred to in earlier embodiments is an array objective lens. Each element in the array is a micro-lens operating a different beam or group of beams in the multi-beam. An electrostatic array objective lens has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is an two electrode decelerating lens.

The bottom electrode of the objective lens is a CMOS chip detector integrated into a multi-beam manipulator array. Integration of a detector array into the objective lens replaces a secondary column. The CMOS chip is preferably orientated to face the sample (because of the small distance (e.g. 100μm) between sample and bottom of the electron-optical system). In an embodiment, capture electrodes to capture the secondary electron signals are provided. The capture electrodes can be formed in the metal layer of, for example, a CMOS device. The capture electrode may form the bottom layer of the objective lens. The capture electrode may form the bottom surface in a CMOS chip. The CMOS chip may be a CMOS chip detector. The CMOS chip may be integrated into the sample facing surface of an objective lens assembly. The capture electrodes are examples of sensor units for detecting secondary electrons. The capture electrodes can be formed in other layers. Power and control signals of the CMOS may be connected to the CMOS by through-silicon vias. For robustness, preferably the bottom electrode consist of two elements: the CMOS chip and a passive Si plate with holes. The plate shields the CMOS from high E-fields.

Sensor units associated with bottom or sample facing surface of an objective lens are beneficial because the secondary and/or back-scatted electrons may be detected before the electrons encounter and become manipulated by an electron optical element of the electron-optical system. Beneficially the time taken for detection of such a sample emanating electron may be reduced preferably minimized.

In order to maximize the detection efficiency it is desirable to make the electrode surface as large as possible, so that substantially all the area of the array objective lens (excepting the apertures) is occupied by electrodes and each electrode has a diameter substantially equal to the array pitch. In an embodiment the outer shape of the electrode is a circle, but this can be made a square to maximize the detection area. Also the diameter of the through-substrate hole can be minimized. Typical size of the electron beam is in the order of 5 to 15 micron.

In an embodiment, a single capture electrode surrounds each aperture. In another embodiment, a plurality of electrode elements is provided around each aperture. The electrode elements are examples of sensor elements. The electrons captured by the electrode elements surrounding one aperture may be combined into a single signal or used to generate independent signals. The electrode elements may be divided radially (i.e. to form a plurality of concentric annuluses), angularly (i.e. to form a plurality of sector-like pieces), both radially and angularly or in any other convenient manner.

However a larger electrode surface leads to a larger parasitic capacitance, so a lower bandwidth. For this reason it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance.

A larger outer diameter of the electrode may also lead to a larger crosstalk (sensitivity to the signal of a neighboring hole). This can also be a reason to make the electrode outer diameter smaller, especially if a larger electrode gives only a slightly larger detection efficiency, but a significantly larger crosstalk.

The back-scattered and/or secondary electron current collected by electrode is amplified. The purpose of the amplifier is to enable sufficiently sensitive measurement of the current received or collected by the sensor unit to be measured and thus the number of back-scattered and/or secondary electrons. This can be measured by current measurements or the potential difference over a resistor. Several types of amplifier design may be used to amplify back-scattered and/or secondary electron current collected by electrode for example a Trans Impedance Amplifier.

An exemplary embodiment is shown in **FIG. 4** which illustrates a multibeam objective lens 401 in schematic cross section. On the output side of the objective lens 401, the side facing the sample 208, a detector module 402 is provided. Detector module 402 is an example of an electron detection device. **FIG. 5** is a bottom view of detector module 402 which comprises a substrate 404 on which are provided a plurality of capture electrodes 405 each surrounding a beam aperture 406. Beam apertures 406 are large enough not to block any of the primary electron beams. Capture electrodes 405 can be considered as examples of sensor units which receive back-scattered or secondary electrodes and generate a detection signal, in this case an electric current. The beam apertures 406 may be formed by etching through substrate 404. In the arrangement shown in **FIG. 5,** the beam apertures 406 are shown in a rectangular array. The beam apertures 406 can also be differently arranged, e.g. in a hexagonal close packed array as depicted in **FIG. 6.**

**FIG. 7** depicts at a larger scale a part of the detector module 402 in cross section. Capture electrodes 405 form the bottommost, i.e. most close to the sample, surface of the detector module 402. In operation, the array of capture electrodes 405 face the sample 208. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallization layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

**FIG. 4** depicts a three-electrode objective lens but it will be appreciated that any other form of objective lens, e.g. a two-electrode lens, may also be used.

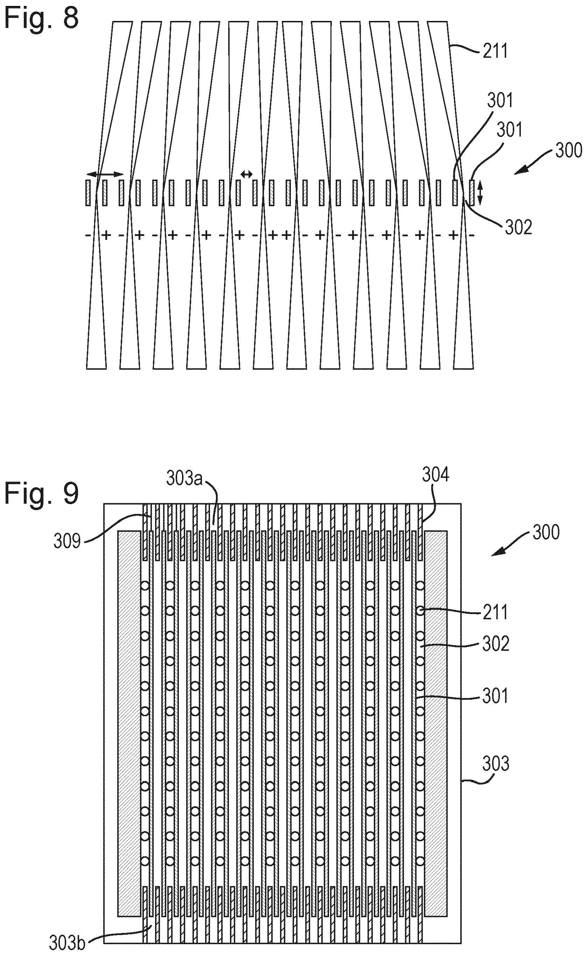

In an embodiment of the invention, the correctors 235 at the intermediate focuses 233 are embodied by a slit deflector 300. Slit deflector 300 is an example of a manipulator and may also be referred to as a slit corrector. As shown in **FIGS. 8** and **9,** slit deflector 300 comprises a set of elongate electrodes 301, e.g. parallel plates or parallel strips, defining a set of slits 302. Electrodes 301 may be formed of silicon or a metal, for example doped silicon regions of a substrate and metallization layers formed on a substrate. Silicon electrodes can be formed by selective etching of a silicon wafer.

Slit deflectors 300 functioning as aberration correctors may alternatively or in addition be positioned just below the condenser lenses 231.

A line of sub-beam paths interposes a pair of elongate electrodes, that may take the form of an array of strips, so that a potential difference between the electrodes causes a deflection of the sub-beams. The direction of the deflection is determined by the relative polarity of the potential difference in a direction relative to the optical axis. The magnitude of the deflection is determined by the magnitude of the potential difference, the distance between the electrodes and the width of the electrodes in the direction parallel to the propagation of the sub-beams. These dimensions may be referred to as the width and depth of the slit, respectively. In an embodiment the width of the slits is in the range of from 10 to 100 μm, desirably 50 μm. In an embodiment the pitch of the slits is in the range of from 50 to 200 μm, desirably 100 μm. In an embodiment, the depth of the slit is in the range of from 50 to 200 μm.

In an embodiment, the electrodes are at the same potential along their lengths and the slit is of constant width or depth so that all sub-beams passing through a given slit experience substantially the same deflection as they all have substantially the same energy.

In an embodiment, the slit may have a non-constant cross-section, e.g. a variation in width or depth, to provide a predetermined variation in the deflection in the sub-beams according to their position along the length of the slit.

In an embodiment, the elongate electrodes define a set of parallel slits such that each of the sub-beams pass through a slit. Thus, facing elongate surfaces of the respective elongate electrodes define a corresponding slit. Desirably the potentials applied to each electrode surface are individually controllable so that the deflection can be controlled as a function of beam position in a direction perpendicular to the longitudinal direction of the slits. In an embodiment a predetermined set of voltages are applied to the electrodes to provide a predetermined set of deflections. For example if the slits extend in along a Y axis of a Cartesian coordinate system (i.e. the elongate direction of the electrodes is in a Y direction), deflection can be controlled as a function of sub-beam position in an X direction.

In an embodiment, each slit is defined by two dedicated electrodes. Opposite potentials are applied to alternate electrodes, for example odd-numbered electrodes are negative and even numbered electrodes are positive. The magnitudes of the applied potentials can be varied with position so as to provide a desired deflection that varies with position in the direction perpendicular to the length of the electrodes. For example the potentials increase linearly and the potential differences likewise increase linearly. For example, one set of electrodes, e.g. the even ones, can be kept at a constant potential, e.g. ground.

In an alternate embodiment, each electrode (except for the electrodes at the end of the array) serves to define one side of each of two slits. That is, in general, the opposite surfaces of the electrodes extending in the direction of the beam paths define in part adjoining slits. In such an arrangement, the potential applied to electrode 'n' relative to the potential applied to electrode '0' is the sum of the potential differences applied across slits '1 to n'. A linear increase in potential differences therefore results in the absolute potentials applied to the electrodes increasing more quickly than linear. In general, the potential differences increase monotonically across the array.

In an embodiment, a plurality of slit deflectors are provided adjacently in the beam propagation direction. Such an arrangement may be referred to as a stack of slit deflectors. The slit deflectors in a stack are differently oriented.

In an embodiment, the sub-beams are arranged in a rectangular array and two slit deflectors are provided with the slits of a first slit deflector being oriented perpendicularly to the slits of the second slit deflector. The slit deflectors may be provided in any order in the stack. Further details of a slit deflector may be found in EPA20156253.5, in which the description of a multi-beam deflector apparatus is hereby incorporated by reference.

In an embodiment, the sub-beams are arranged in a hexagonal array and two slit deflectors are provided. The slits of the first slit deflector are orthogonal to the slits of the second slit detector. The second slit detector has a smaller pitch than the first slit detector and fewer sub-beams per slit than the first slit detector. The slit deflectors may be provided in any order in the stack.

Other arrangements of multiple slit deflectors may be provided for other arrangements of sub-beams. For example the slits might be arranged as concentric hexagons.

In an embodiment of the invention, multiple beams pass through a slit defined by a pair of electrodes. This substantially reduces the number of connections required to provide the deflection potentials. In a multi-beam tool with many hundreds or thousands of beams, it is difficult, if not impossible, to provide independent deflection potentials for each sub-beam since there is limited space for wiring or circuit traces (routing). This problem is addressed by the present invention since the number of traces required is significantly reduced. In some cases, an embodiment of the invention may not be capable of completely correcting an aberration, for example a $3^{rd}$ order rotationally symmetric aberration. However, an embodiment of the invention can effect a significant and useful reduction even in aberrations that cannot be completely corrected.

A slit deflector as described above may introduce a slight focusing effect in the direction that the beam is deflected. If two or more differently oriented slit deflector arrays are used there will be a focusing affect in two or more directions. The magnitude of this focusing effect is proportional to the magnitude of the deflection. In some cases, this focusing effect may be undesirable.

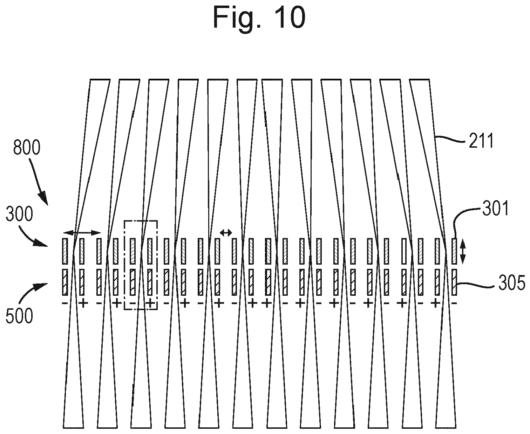

To compensate for the focusing effect of a slit deflector, a slit lens may be added. As shown in **FIG. 10,** a slit lens 800 comprising an array 300 of elongate electrodes 301 (which define a first array of elongate slits) and at least a further array 500 of corresponding elongate electrodes 501 (which define a second array of elongate features. Each array of elongate electrodes is formed with a structure with a similar shape to that of the slit deflectors referred to earlier in this description. The lens is made by having a potential difference between the average of the two deflector electrodes and the two slit electrodes. This is done by either changing the potential of the slit electrodes or by adding a voltage offset to the deflector electrodes.

The elongate electrodes 301 may be set at respective potentials, and the corresponding elongate electrodes 501 may be set at a ground potential or at respective different potentials. The strength of each slit lens can be selected such that it makes the astigmatism equal to the astigmatism of the slit deflector with the largest deflection. In an embodiment where the corrector consists of a deflector and a slit lens arrays for each axis (normally two, one for each of X and Y), the resulting astigmatism has the characteristics of a micro lens array.

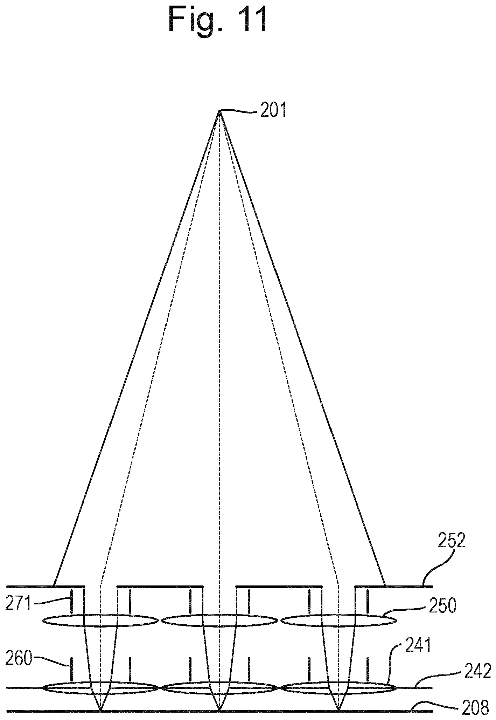

**FIG. 11** is a schematic diagram of another design of exemplary electron-optical system. The electron-optical system may comprise a source 201 and electron-optical column comprising a plurality of electron optical elements. (In another arrangement the electron-optical column comprises the source 201.) The electron optical column may comprise an objective array assembly as shown and described with respect to **FIG. 3.** Such an objective array assembly may feature a control lens array 250, an objective lens array 241, and a detector array.

In the present arrangement depicted in **FIG. 11** the objective lens array may also feature an upper beam limiter 252, a collimator element array 271, a scan deflector array 260, and a beam shaping limiter 242. (Note in a different arrangement the electron optical column comprises these features without them being arranged in a common lens assembly.) The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures, e.g. the upper beam limiter 252. The source 201 is desirably a high brightness thermal field emitter with a good compromise between brightness and total emission current.

The upper beam limiter 252 defines an array of beam-limiting apertures and functions as a beam separator or sub-beam generator. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator (not shown). Such a macro-collimator may be up beam of the upper beam limiter 252. Thus the macro-collimator operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

The scan-deflector array 260 comprises a plurality of scan deflectors. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect rays in the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally).

In an embodiment, the scanning deflectors described in EP2425444, which document is hereby incorporated by reference in its entirety specifically in relation to scan deflectors, may be used to implement the scan-deflector array 260. The scan-deflector array 260 is positioned between the objective lens array 241 and the control lens array 250. In the embodiment shown, the scan-deflector array 260 is provided instead of a macro scan deflector. A scan-deflector array 260 (e.g. formed using MEMS manufacturing techniques as mentioned above) may be more spatially compact than a macro scan deflector.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

The provision of a scan-deflector array 260 instead of a macro scan deflector can reduce aberrations from the control lenses. This is because the scanning action of the macro scan deflector causes a corresponding movement of beams over a beam shaping limiter (also referred to as a lower beam limiter) defining an array of beam-limiting apertures down-beam of at least one electrode of the control lenses, which increases a contribution to aberration from the control lenses. When a scan-deflector array 260 is used instead the beams are moved by a much smaller amount over the beam shaping limiter. This is because the distance from the scan-deflector array 260 to the beam shaping limiter is much shorter. Because of this it is preferable to position the scan-deflector array 260 as close as possible to the objective lens array 241 (e.g. such that the scan-deflector array 260 is directly adjacent to the objective lens array 241 as depicted in **FIG. 11.**

The smaller movement over the beam shaping limiter results in a smaller part of each control lens being used. The control lenses thus have a smaller aberration contribution. To minimize, or at least reduce, the aberrations contributed by the control lenses the beam shaping limiter is used to shape beams down beam from at least one electrode of the control lenses. This differs architecturally from conventional systems, such as shown in and described with respect to **FIG. 3.** in which a beam shaping limiter is provided only as an aperture array that is part of or associated with a first manipulator array in the beam path and commonly generates the multi-beams from a single beam from a source.

In the embodiment of **FIG. 11,** a collimator element array 271 is provided instead of a macro collimator. Although not shown, it is possible to use a macro collimator in the embodiment of **FIG. 11,** to provide an embodiment having a macro-collimator and a scan deflector array 260. Another variation may have a macro-collimator and a macro-scan deflector. It is also possible to have a variation of the embodiment of **FIG. 11** with a macro scan deflector and a collimator element array. Each collimator element collimates a respective sub-beam. The collimator element array 271 (e.g. formed using MEMS manufacturing techniques) may be more spatially compact than a macro collimator. Providing the collimator element array 271 and the scan-deflector array 260 together may therefore provide space saving. This space saving is desirable where a plurality of the electron-optical systems comprising such an objective lens assembly is provided in an electron-optical system array (e.g. an array of multi-beam columns). In such an embodiment there may be no macro condenser lens or a condenser lens array. In this scenario the control lens therefore provides the possibility to optimize the beam opening angle and magnification for changes in landing energy.

As described above, multiple electron-optical components in an electron optical column (such as a multibeam SEM or multibeam lithographic machine) are typically required to create a plurality of beams. The electron-optical components form electron optical apertures, lenses, deflectors and perform other manipulations of the beams. These electron optical components may include MEMS elements and need to be aligned accurately to allow all beams to land on a target (for example a sample or a detector). MEMS elements which are in close proximity to each other can be stacked on top of each other and are relatively easy to align.

MEMS elements which need to be spaced apart may be aligned mechanically in a column to a certain tolerance, for example elements might need to be mechanically aligned to a tolerance of order 10 μm and/or 1 mrad. For operation, finer electron-optical tolerances are required, such for alignment relative to the beams source, such as of 10 to 20 nm. Achieving tighter tolerances for a final alignment be done electron-optically with an electron-optical corrector such as a deflector for example as described previously in this description.

The correction for alignment may be over the whole multi-electron beam arrangement, with respect to groups of sub-beams comprising the multi-electron beam arrangement such as a strip corrector or for alignment that may be specific for each sub-beam, e.g. may vary from sub-beam to sub-beam, for example using an individual beam corrector. The process of correctly aligning the element, e.g. for final alignment, is referred to as column alignment. Column alignment considers the positions of the sub-beams within the multi-electron beam in the plane of the sample, i.e. their relative displacement in the sample plane for example expressed in Cartesian coordinates in X and Y.

A known process of column alignment uses a detector placed at the target (sample) position e.g. on a sample stage. Desirably, the detector is able to detect all beams simultaneously to minimize the time taken for the column alignment procedure. A known detector requires a detector plate that is held on a movable stage that can be positioned at the target location (such as a sample stage). The detector plate has a patterned surface with a pattern which may correspond to the arrangement of sub-beams in the multi-electron beam. The patterned surface is a plane of a sample surface. The alignment is in effect in a plane of the sub-beam and, expressed in Cartesian coordinates, is in an alignment in the X and Y axes. Downbeam of the patterned surface is a scintillator which scintillates where electron-beams impinge on it. A photonic detector such as a camera, e.g. a CCD device, may be positioned downbeam of the scintillator so as to detect a parameter of light generated by each beam such as its intensity. The alignment between detector plate and the camera is challenging for example in resolving the different light beams generated in the scintillator which may be only of the order of 50 to 100 micrometers apart..

It is proposed to perform column alignment of elements of an electron-optical column (especially arrays of apertures such as the condenser lens array and the objective lens array, which can be MEMS elements) by using a charged-particle detector, such as a detector array, which can detect a multitude of beams simultaneously, at a fixed position in the electron-optical column. The detector is positioned towards the bottom of the electron optical column, preferably at the bottom of the electron-optical column. The detector is close to the plane of a sample surface so that the detector can receive a sufficient number of secondary electrons for a detection signal from a sample for example during inspection.. The position of the detector may be more proximate to the sample surface than the scintillator and photonic detector of for example the sensor in the stage.

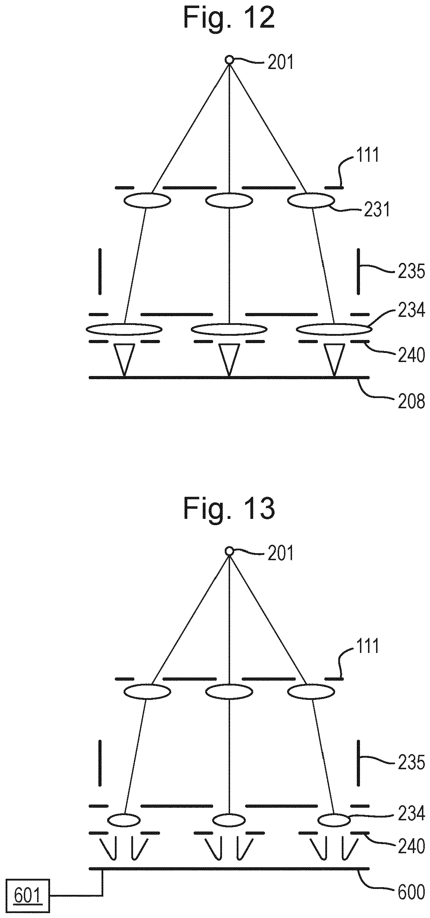

The charged particle detector is desirably a detector module that is used in an inspection tool to detect electrons, such as secondary electrons and backscatter electrons, that are generated when the primary electrons are incident on a sample. Thus the charged particle detector may have two functions. The charged particle detector has a function to detect a property of a sample when the inspection tool is operated in an inspection mode (depicted in **FIG. 12**). Another a function of the charged particle detector is to detect alignment when the inspection tool is operated in a calibration mode (depicted in **FIG. 13**).

Various approaches can be used to provide a flow of charged particles to the charged particle detector that is dependent on column alignment. Desirably, the current of returning electrons to each detector element is proportional (or at least monotonically related) to the current of the respective sub-beam at the sample position. In the case of misalignment, the sub-beam current will be reduced, e.g. because parts of the sub-beam intersect elements of the electron-optical column and are scattered or absorbed. Optimum alignment of a beamlet is therefore achieved when the current signal from the associated detector is a maximum. On detection of misalignment, the detector signal is used to control a relevant corrector as described above to increase the detector signal of the corresponding sub-beam and desirably to maximize the detector signal.

The present invention can be applied to tools featuring a multi-electron beam configuration such as metrology and inspection tools and lithographic apparatus of various different architectures, including those depicted herein but also others. The exemplary inspection tool shown in **FIGs. 12** and **13** has a charged particle source 201 which emits charged particles toward aperture plate 111 (or beam limiting aperture array) which generates from (e.g. by splitting, separating or dividing) the charged particles a plurality of sub-beams, much like that depicted and described with reference to **FIG. 3.** The aperture plate therefore functions as a sub-beam generator. Condenser lenses 231 direct respective sub-beams to intermediate foci. A deflector 235 (which may be a macroscopic deflector or a deflector array) adjusts the direction of propagation of the sub-beams. An objective lens array 234 focuses respective sub-beams toward the sample 208. Electron detection device 240, or detector module, detects returning electrons, e.g. secondary electrons emitted by the sample.

In an embodiment of the invention, a charged particle mirror, e.g. an electron mirror for electron beams, is used to reflect the primary charged particle beams back towards the charged particle detector, as shown in **FIG. 13.** An charged particle mirror can be created by positioning an object 600 downbeam of the charged particle detector and the last electron-optic element of the electron-optic column. The object 600 may be a sample, the sample holder or another object held by the sample holder. The object 600 is set at a predetermined negative potential difference with respect to the cathode of the charged particle source 201 using potential source 601. If the charged particle beam comprises positively charged particles instead of electrons, a positive potential would be used. The predetermined potential difference may be of the order of -1 to -100 V, e.g. -50 V. Desirably the predetermined potential difference is greater in magnitude than the intra- and inter-beam energy spread. The potential difference between object and cathode will cause each beam to reverse direction towards the charged particle detector. The greater the magnitude of the potential difference, the shorter the distance required to reverse the trajectories of the charged particles. The objective lens array can be set to a particular voltage to optimize the detection yield.

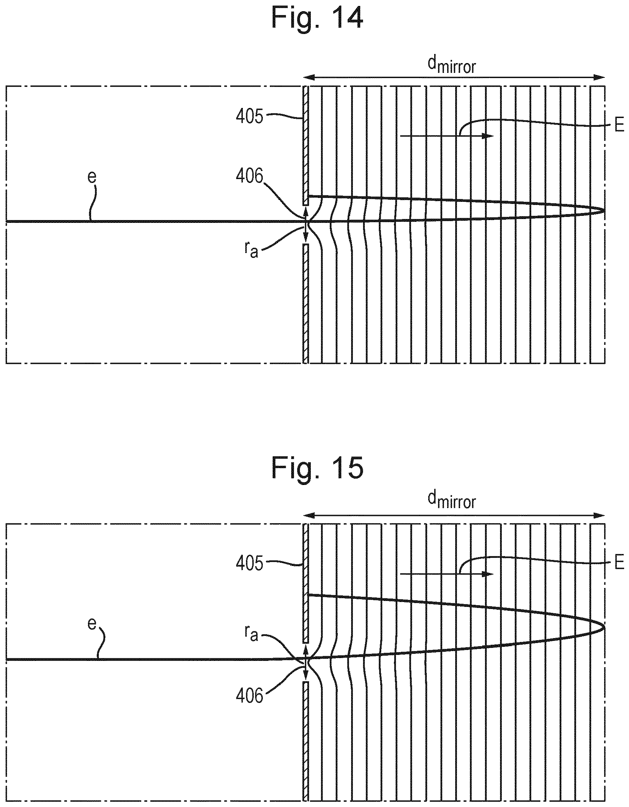

Example trajectories of an electron in an embodiment using an electron mirror are depicted in **FIGs. 14** and **15.** In this embodiment, the detector module forms the final element of the electron-optical column. In **FIG. 14,** an electron $e$ propagating in the downbeam direction enters the electric field region via a negative aperture lens formed by aperture 406 in the detector module 402. Its s beam potential is taken as U , its velocity parallel to the electron-optical axis as $v_z$ and velocity perpendicular to the electron-optical axis as $v_r$. The velocity of electron $e$ perpendicular to the electron-optical axis, for example in a radial direction, is taken to be zero in its trajectory as it leave the aperture lens, i.e. $v_r = 0$. After propagating along a trajectory beyond the aperture the electron $e$ is decelerated by an electric field E to a full stop, i.e. to a stationary point. The stationary point is at distance, $d_{mirror}$, along the electron-optical axis from the aperture 406:

$$d_{mirror} = \frac{U}{E} \ . \tag{1}$$

Then the electron $e$ is accelerated in the reverse (upbeam) direction. To calculate the radial distance $\Delta r$ travelled by the electron $e$ from the electron-optical axis, the focal distance $f$ for the negative aperture lens should be noted. This focal distance $f$ given by:

$$f = \frac{4U}{E} \tag{2}$$

Here $E$ is the electric field in the aperture which is set by a potential difference between the sample and the plate in which the aperture 406 is defined, for example the bottommost electrode of an objective lens array 242 and/or on the detector plate.. This results in a radial velocity:

$$v_r = \frac{h}{f} v_z \tag{3}$$

Here $h$ is the distance at any point in the trajectory of the electron $e$ from the aperture 406 to the electron-optical axis of the aperture lens. If $d_{mirror}$ is much larger than the distance over which the electron gains radial velocity (which is of the order of the aperture size) the radial distance travelled can be calculated as

$$\Delta r = v_r \times 2 t_{mirror} \tag{4}$$

where

$$t_{mirror} = 2 \frac{d_{mirror}}{v_z} \tag{5}$$

Here $t_{mirror}$ is the time for an electron to travel the distance $d_{mirror}$. This results in the radial distance h travelled by the electron $e$ when it reaches a capture electrode 405 of the detector given by $\Delta r = 4 \ h. \ d_{mirror}/f,$ which is independent of beam potential $U$ and electric field $E$. This means that at least some electrons which pass through the aperture 406 away from the electron-optical axis will achieve sufficient radial displacement to contact capture electrode 405 of detector module 402 surrounding aperture 406. Thus the field between the detector, for example as plate with an array of capture electrodes 405, and the object 600 in effect forms an electrostatic lens. This generates a radial motion as an electron $e$ projects along a trajectory from the aperture 406 and back towards the detector. So long as the lens and the potentials are applied is set up to have the mirror point beyond a threshold distance, some electrons that pass through the aperture reach the capture electrode 405 of the detector. Therefore, a signal indicating the number of returning (reflected) electrons can be generated as a signal representing the alignment of the relevant elements of the electron-optical column. Note the radial distance should be sufficient such that a returning electron $e$ travels further than the radius of the aperture 406 so it can reach a capture electrode 405

**FIG.** 15 depicts the trajectory of an electron that leaves the aperture at an angle to the electron-optical axis α where the angle is a ratio of the radial velocity $v_r$ and the velocity parallel to the electron-optical axis $v_z$, i.e. $\alpha = \frac{v_r}{v_z}$. In this case, the displacement is given by:

$$\Delta r = v_r \times 2t_{mirror} = \alpha \times 4d_{mirror} \qquad (6)$$

Such an angled trajectory of the electron (e.g. beamlet) could be generated by a deflector operating on the trajectory (or path) up-beam of the aperture, e.g. the objective lens. Additionally or alternatively, the angled trajectory be caused by a lensing element such as the objective lens itself (in which the aperture may be formed). Using an objective lens array as described with reference to FIGS. 3 and 11, for example using MEMS elements, the angle of the electron could be $\alpha$ = 10 mrad.

In an exemplary embodiment of the objective lens may create a focus of between ~50 to 100 micron. With a mirror distance of about one millimeter, i.e. $d_{mirror}$ = 1 mm, an electron $e$ would achieve a radial distance sufficient to be clear of the aperture 406, e.g. 40 $\mu$m. If the beam potential at the aperture lens is 2.5 kV, the mirror action can be achieved with an electric field of 2.5 kV/mm. Because the distance to the mirror is much larger than the focus, there should be sufficient electrons in the 'focused' beam with an angle large enough to end up on the detector, so again sufficient electrons will be deflected to the capture electrodes to provide a signal representing the alignment of the relevant elements of the electron-optical column

The signal generated by the reflected electrons does not have to have a large amplitude since the measurement is not time critical and a low signal can be compensated for by increasing the measurement time. In addition, it is possible to tilt the object by a small amount, e.g. of the order of 1 mrad, to create an electric field that is not parallel to the electron-optical axis of the objective lens, as shown and described with respect to **FIG. 15.** The tilt is effected by the positioning system that controls the support, such as the stage, that supports the object. The positioning system may tilt the sample at an angle that is not parallel to the objective lens array. In other words the object 600 is not perpendicular to the electron-optical axes of the objective lenses. This will provide an additional radial deflection of the returning electrons to ensure that the returning electrons intersect a capture electrode of the detector module rather than return through the aperture 406.

Thus sufficient electrons can be detected by the detector for beam alignment controlling the distance between the aperture and the sample, the angle of propagating electron $e$ travels from the aperture 406 towards the sample and the relative tilt of the sample for example to the electron-optical axis. Specifically this is because the radial displacement is proportional to $d_{mirror}$, the distance from the aperture to the stationary point in the electron trajectory along the electron-optical axis. As this distance is determined by the ratio of the beam potential (U) to the potential difference (e.g. the electric field in the aperture), when the potential difference is equal to the beam potential, the distance $d_{mirror}$ is the distance between sample and aperture. For a larger radial displacement, the sample can be placed further away from the aperture.

There are few requirements on the object used to form the electron mirror and in particular its surface. The electrons do not contact the object and its surface simply needs to be flat, enough e.g. sufficiently planar, so that uniformity of the electric field is maintained. That is the variance and deviation of the surface of the object from an ideally planar surface does not affect the uniformity of the electric field.

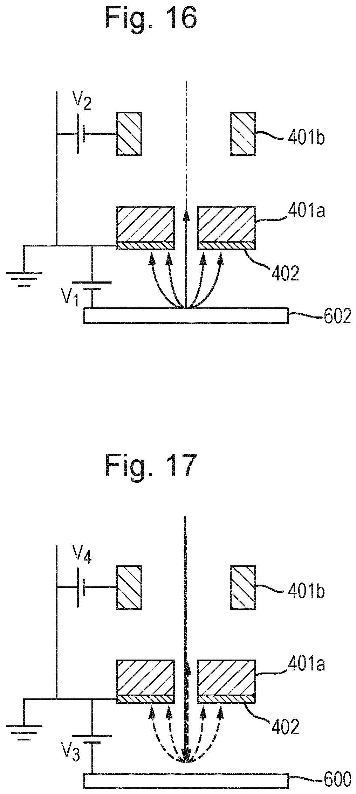

In another embodiment of the invention, instead of an electron mirror, a calibration target 602 is provided in the path of the beamlets, for example in place of the sample. Such an arrangement is shown in **FIG. 16.** The calibration target can be a flat or planar plate, optionally with a uniform coating, or a silicon wafer which may be uncoated, i.e. bare such as an unprocessed wafer. The calibration target may be a metal plate. The calibration target may be a sample or a dummy sample supported by the sample holder. The calibration target can be a part of a portion of the surface the sample stage, for example close by the sample holder and the position of the sample during operation. The surface of the sample or dummy sample may be positioned at the same plane or substantially the same plane as a sample on the sample holder. In use the calibration target may have a surface that is substantially coplanar with a sample when supported by the sample holder.

The calibration target 602 has a known response (in terms of secondary electrons generated in response to a given primary beam current) that is desirably constant across its area. The known response of the calibration target 602 may be determined by calibrating its performance in response to the primary beams relative to a standard calibration target, for example to generate secondary electrons at controlled calibration settings. Desirably the secondary electron current is monotonically related to, e.g. proportional to, the primary beam current. The calibration target 602 is placed at a known distance from the objective lens.

In the alignment process, the response of the calibration target 602 to a primary beam in generating secondary electrons is measured by the detector module 402, in terms of captured secondary electrons.

The target surface is preferably planar. The target surface is without sharp edges for example on a nanometer scale because of the secondary electron edge enhancement effect, which would make the intensity of a beam spot on the surface vary rapidly with small movements or adjustments The roughness of the calibration target may be around or less than to micrometers; however as the electric field is dominant the flatness of the calibration target is not a stringent requirement.

**FIG. 16** depicts calibration with two potentials, $V_1$ and $V_2$, using a calibration target. The potential $V_1$ is between calibration target 602 and the detector plate 402 and/or the lower electrode 401a of the objective lens. Note that the detector plate 402 may be a separate entity from the lower electrode 401a to which the same potential is applied. Alternatively the detector plate 402 is the integrated into the lower electrode 401a, so sharing a common applied potential. The potential $V_2$ is between another electrode 401a of the objective lens and the detector plate 402 and/or the lower electrode 401a. In an exemplary embodiment the potential $V_1$ is 50V when the sample 602 is close to the detector 402 (e.g. ~50 micron). The potential $V_2$ is the source potential less the landing energy, when 401b is a top electrode of the objective lens. If element 401b is up beam of the objective lens, for example in another electron-optical element along the beam path, it can have any appropriate value for that location in the electron-optical column.

**FIG. 17** depicts the same lens arrangement as shown in **FIG. 16** with equivalent potential differences $V_3$ and $V_4$ in place of $V_1$ and $V_2$, respectively, adjusted to function as an electron mirror 600. The applied potential $V_3$ to the detector plate 402 and/or lower electrode 401a may be of the order of the beam potential in an electron trajectory at 401a. So if the beam energy is 2 keV , then $V_3$ should be 2 kV. Taking energy spread into consideration, 1 to 100 volts are added on; so that the potential $V_3$ applied to the detector plate 402 and/or lower electrode 401 is between 2.0 and 2.1 kV. Thus the voltage setting of the bottom electrode of an objective lens in a mirror arrangement is effectively the matching potential of the bottom electrode to the beam energy. If this is not done, the mirror will not work. V4 is set at the source potential 30 kV minus the landing energy when V3 is zero (i.e. the landing energy is the sample potential if the electron were to land on the sample, in operational or inspection mode).. This assumes 401b is another electrode of the objective lens, e.g. an upper electrode. In a different arrangement, 401b could be any element up beam of the bottom electrode and then the potential of the element 401b are whatever the component is intended to have in the specific electron-optical design.

In the above described embodiments of the invention, the detector module need not be at the bottom surface of the objective lens but can instead be further up the electron-optical column, for example within the objective lens or above an objective lens array. Note for the arrangements of **FIGs 16** and **17** in which up beam element 401b is an electron optical element up beam of the objective lens array, the circuit features showing the applied potentials may well be different from those depicted.

A suitable location in the objective lens may be either immediately down beam or integrated into the down beam facing surface of an objective lens electrode other than the down-beam-most electrode, e.g. a most upbeam or intermediate electrode. Suitable locations include: downbeam of an electron optical element; upbeam, for example immediately upbeam, of the objective lens array; or upbeam of the electron-optical element at a position upbeam of the objective lens array. Such an electron-optical element may be an additional lens such as a control lens array, for example, in an objective lens assembly shown and described with reference to **FIGs. 3** and **11;** or in a detector array above an objective lens assembly as shown and described with reference to **FIG. 3.**

Note having the detector array located above the objective lens assembly of **FIG. 3** is feasible because the beamlets are up beam of the objective lens assembly. For such a detector upbeam of the objective lens array, the electron-optical column may feature a bi-directional deflector array, which may feature a Wien filter array, operates on returning electrons differently from primary electrons, so that the primary electrons are directed to the sample or target and the returning electrons are directed the array of detector elements positioned off the path of the primary electron beamlet.

Although a current detector such as capture electrodes has been described, other types of detector architecture may be used such as PIN detector elements, detector elements which detect electrons dependent on band-gap energies, and scintillators. On more of the detector types may be preferred to be used at an upbeam location than in an array facing the sample; whereas a current electrode is preferred to be located proximate to the sample in view of the way in which the signal to noise ratio changes with distance away from the sample..

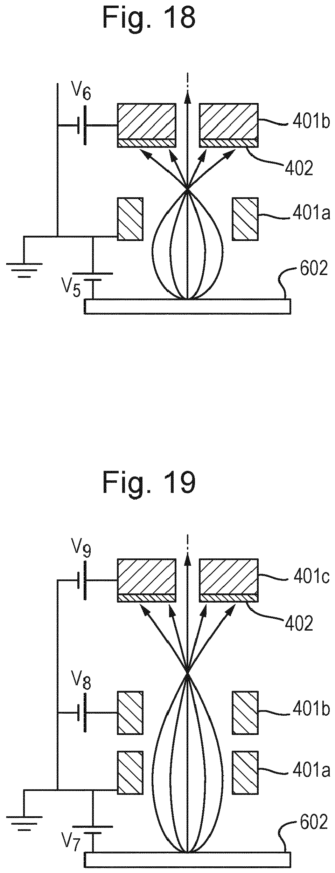

Various such arrangements are shown in **FIGs. 18** to **20** having a detector located at position further upbeam than associated with the bottommost electrode of the objective lens.. As shown in all the arrangements depicted in these figures, when the detector module 402 is located above the lowest (i.e. most down beam) electrode of the objective lens, the returning electrons may pass through a cross-over before arriving at the detector module. Further for a sufficient number of returning electrons such as reflected or secondary electrons to return through an electrode, the aperture in the bottommost electrode may be larger than for an aperture when the detector faces the sample pr calibration target.

**FIGs. 18** and **19** show different arrangements using a calibration target to generate returning secondary electrons. In **FIG. 18** the detector module 402 is positioned on or associated with a downbeam facing surface of an up beam electrode of an objective lens array with at least two electrodes. The applied potentials $V_5$ and $V_6$ may be similar to the

potentials $V_1$ and $V_2$ applied to the arrangement depicted in **FIG. 16. FIG. 18** depicts a crossover (or focus) in the path of the secondary electrons because of the lensing effect of the objective lens. The secondary electrons have lower average energy than the primary electrons. Thus the crossover (or focal point) is closer to the sample surface than the object point of the primary beam. The focus in the figure is a schematic representation; the exact location of the focus for the secondary electrons may be closer to the sample than depicted.

**FIG. 19** shows an arrangement similar to that as shown in **FIG. 18,** except the detector module 402 is positioned on the upper electrode 401c of a three-electrode objective lens. The applied potentials to the three depicted electrodes 401a, 401b and 401c are $V_7$, $V_8$ and $V_9$. The potentials $V_7$ and $V_9$ correspond to the potentials $V_5$ and $V_6$. $V_8$ is a potential lower than $V_9$ In alternative interpretation of the arrangements shown in **FIGs. 18** and **19,** these figures depict the detector module 402 at a position along the beam path above the objective lens 401a, for example down beam or up beam of a control lens or within or upbeam of an objective lens assembly.

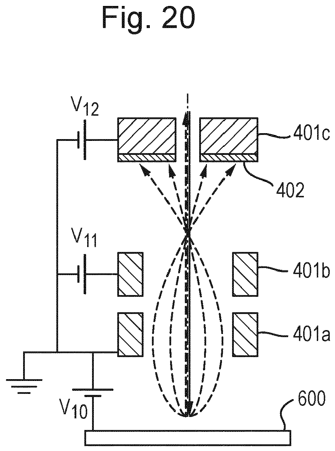

**FIG. 20** shows an electron mirror 600 used to generate returning secondary electrons. The detector module 402 is positioned on the upper electrode 401c of a three-electrode objective lens. The features depicted in FIG. 20 correspond to those shown in FIG. 19. The potentials $V_{10}$, $V_{11}$ and $V_{12}$ applied to the electrodes 401a, 401b and 401c in general correspond to the potentials $V_7$, $V_8$ and $V_9$. However, the potential applied to the downbeam-most electrode 401a and/or detector plate 402 may be effectively matched with the beam energy, with an offset, such as between 1 to 100V, to account for energy spread of the returning electrons. In an alternative arrangement, the objective lens may have a different number of electrodes, for example two.

In the arrangements depicted in **FIGs. 16** to **20** the bottom electrode is shown grounded. This one arrangement. In a different arrangement, an upbeam electrode of the objective lens array is grounded, and a negative potential difference is applied the lower, bottommost electrode of the objective lens array; and then also to the sample. In such an arrangement, the potentials applied to the bottom electrode 401a and/402 in the different arrangements depicted would be $V_2$, $V_4$, $V_6$, $V_9$ or $V_{12}$ respectively in place of $V_1$, $V_3$, $V_5$, $V_7$ or $V_{10}$ with polarity opposite to that described in respect to FIGs 16 to 20. As these two arrangements demonstrate, what matters is the relative potential differences between the electrodes rather than their absolute voltages. Further the various potential settings for the sample and electron-optical components such as the detector and the bottom-most electrode described and depicted herein are exemplary. Any arrangement of potential settings may be used which archieve the functions herein described.

The detector module can be a dedicated detector for alignment purposes rather than the detector used for imaging.

In all embodiments of the invention, alignment is a simple procedure performed in a calibration mode. The electron-optical column is operated to generate sub-beams which are directed to the mirror or calibration target. A parameter affecting alignment, e.g. a setting of a corrector such as a deflector such as herein described, is varied whilst the returning electrons are detected. Variation of the control parameters of the corrector may be operated to adjust the alignment of a corresponding sub-beam. The value of the parameter, e.g. corrector setting, that results in maximum value for the returning current indicates optimum alignment. The parameter value which determines an alignment of a sub-beam is determined for all sub-beams using the corresponding corrector or a number of correctors arranged along the sub-beam path. The optimum parameter values for the all sub-beams determine an alignment setting of the corrector arrays for the multi-beam arrangement, i.e. all sub-beams of the multi-beam arrangement. That is, detection of a uniform signal preferably at a maximum for all detector elements of a detector may indicate alignment. Use of the alignment setting may thus achieve mutual alignment of the sub-beams of the multi-beam arrangement and thus alignment of the multi-beam arrangement. The alignment setting may then be used during an inspection mode of the tool. The same approach can be used with correctors in the form of macro deflectors (i.e. affecting all beams at once) or micro deflectors (i.e. affecting individual sub-beams or groups of sub-beams). The calibration procedure can be performed on commissioning of the tool and periodically, e.g. during routine maintenance. Alignment may drift due to variations in voltages provided by power supplies and may be performed at a frequency related to drift in power supplies, e.g. daily.

For an arrangement as shown in and described with respect to **FIG. 3,** the source, condenser lens array and objective lens array (which may be part of a stack of electron-optical elements of the objective lens assembly) may be respectively aligned with each other, in pairs and/or together. Similarly, the arrangement described in reference to **FIG. 3** featuring a source, a macro scan deflector and an object lens array (for example as part of an objective lens assembly feature a series of stacked electron-optical components) may be respectively aligned with each other in pairs and/or together.

For the embodiment shown in and described with reference to **FIG. 11,** all the electron-optical components besides the source are in a lens assembly, such as an objective lens assembly, in which all the electron-optical components are mechanically stacked and integrated with each other. However such an electron-optical system could still have tilt misalignment between the source and the lens assembly. The invention may be applied to such an electron-optical system. To implement the corrective alignment, a macro corrector such as a scan deflector may be located upbeam of the objective lens assembly, downbeam of the source. Similarly, the variation with a scan deflector array and a macro collimator requires an additional component of a macro corrector e.g. a macro-deflector up beam of the objective lens assembly.

Further, an electron-optical column having an arrangement described with respect to **FIG. 11** and its variations has its sub-beams shaped by the beam-shaper which is downbeam of the objective lens array rather than the most-upbeam element of a lens assembly. However the sub-beams are generated by an upper beam limiter which is pre-aligned in the objective lens assembly. Therefore this different arrangement, for example in terms of the pre-alignment of the upper beam limiter (which can be referred to as a beam generator or separator) with the beam shaper should be taken into account when operating correctors to achieve alignment between the sub-beams.

The column alignment procedure using this invention is advantageous because it does not require a target in the path of the primary sub-beam that scintillates in response to the primary beam. The sub-beams of the multi-beam may be measured directly or indicative secondary electrons may be measured directly without conversion to a photonic signal. Use of the detector within the column for alignment beneficially does not require an accurate target placement or use of a surface of the stage. (The use of the additional area on the stage may add surface area and thus mass to the stage, influencing the stage dynamics.) Such a detector avoids the need for a challenging alignment of a camera to a detector plate, for example within the detector.

The alignment procedure should be repeated periodically to address drift in the settings of external power supplies and potential sources. Alignment of an electron-optical column or system may done daily, every week or every month.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools.

A multi-beam electron beam tool may comprise a gun aperture plate or Coulomb aperture array (not shown). The gun aperture plate is a plate in which apertures are defined. It is located in an electron-optical column downbeam of the source and before any other electron-optical device. In FIG 3 it would be located between the source 201 and the condenser lens array 231. The gun aperture plate 271, in operation, is configured to block off peripheral electrons of primary electron beam 202 to reduce Coulomb effects in the beam before the beam separator, for example in or associated with the condenser lens array. However, the gun aperture array may have fewer apertures than the condenser lens array and a number of apertures fewer than the number of beamlets that are down beam in the multi-beam. As a gun aperture array is a type of aperture array and is spaced apart from other beam limiting aperture arrays, such as the condenser lens array and the objective lens array, it may be considered in the alignment procedure too.

Exemplary embodiments of the invention are described below in the following numbered paragraphs:

Paragraph 1. A charged-particle tool configured to generate a plurality of sub-beams from a beam of charged particles and direct the sub-beams downbeam toward a sample position, the tool charged-particle tool comprising; at least three charged-particle-optical components; na detector module configured to generate a detection signal in response to charged particles that propagate upbeam from the direction of the sample position; and a controller configured to operate the tool in a calibration mode; wherein: the charged-particle-optical components include: a charged-particle source configured to emit a beam of charged particles and a beam generator configured to generate the sub-beams; and the detection signal contains information about alignment of at least two of the charged-particle-optical components.

Paragraph 2. A tool according to paragraph 1, wherein the controller is configured to operate the tool in an inspection mode wherein the detection signal contains information about a property of a sample at the sample position.

Paragraph 3. A tool according to paragraph 1 or 2, further comprising a charged particle mirror located downbeam of the objective lens array and operative to reflect charged particles directed toward the sample position back toward the detector module during the calibration mode.

Paragraph 4. A tool according to paragraph 3, wherein the charged particle mirror comprises a potential source configured in the calibration mode to set an object located downbeam of the objective lens array at a predetermined potential relative to the charged-particle source .

Paragraph 5. A tool according to paragraph 4, wherein the predetermined potential is in the range of from about -1 V to about -100 V.

Paragraph 6. A tool according to paragraph 4 or 5, wherein the tool further comprises a sample holder and the object is the sample holder or is held by the sample holder.

Paragraph 7. A tool according to paragraph 1 or 2, further comprising a sample holder configured to hold a calibration target at the sample position during the alignment mode, wherein the calibration target is arranged to emit secondary electrons toward the detector module as the charged particles that propagate upbeam from the direction of the sample position.

Paragraph 8. A tool according to paragraph 7, wherein the calibration target is comprised in the sample holder or the calibration target is supported by the sample holder.

Paragraph 9. A tool according to any one of paragraphs 6 to 8 wherein the controller is configured to control a positioning system to position the object or the calibration target so a surface thereof is tilted with respect to the plane of the of the objective lens array.

Paragraph 10. A tool according to any one of the preceding paragraphs further comprising a corrector, e.g. a deflector, wherein the controller is configured to determine, in the calibration mode, a setting value for a parameter of the corrector to be used in the inspection mode.

Paragraph 11. A tool according to paragraph 10, wherein the controller is configured, in the calibration mode, to vary the parameter of the corrector and to determine as the setting value the value of the parameter that maximizes the signal e.g. the current , of charged particles that propagate upbeam from the direction of the sample position.

Paragraph 12. A tool according to paragraph 10 or 11, wherein the corrector comprises at least one of: an array of individual beam correctors configured to correct each sub-beam; a strip corrector configured to operate on the sub-beams; and a corrector configured to operate on the source beam.

Paragraph 13. A tool according to paragraph 12, wherein the corrector is positioned at or between: a condenser lens array associated with the beam generator, the condenser lens array focusing the sub-beams to an array of intermediate foci; and the intermediate foci.

Paragraph 14. A tool according to any one of the proceeding paragraphs wherein the detector module is a most downbeam component of the electron optical column.

Paragraph 15. A tool according to any one of paragraphs 1 to 13, wherein the detector module is located upbeam of the most downbeam electron optical component of the electron-optical column.

Paragraph 16. A tool of paragraph 14 or 15, wherein the further electron optical element is the most downbeam electron optical element and is an objective lens array, the detector module being associated with the objective lens, desirably: associated with an electrode of the the objective lens array, preferably the electrode of the objective lens array is the most downbeam electrode of the objective lens array; or upbeam of the objective lens array

Paragraph 17. A tool according to claim 14 or 15, wherein:the detection signal contains information about alignment of the most downbeam electron optical element, which is an objective lens array; and the detector module is associated with the objective lens, desirably: associated with an electrode of the objective lens array, e.g. the most downbeam electrode of the objective lens; or the detector module is upbeam of the objective lens.

Paragraph 18. A tool according to any one of the preceding paragraphs wherein the beam generator is a beam-limiting aperture array .

Paragraph 19. A tool according to paragraph 18, wherein the beam limiting aperture array provides an up-beam electrode of a condenser lens array preferably configured to focus each of the sub-beams to a respective intermediate focus;

Paragraph 20. A tool according to paragraph 18, wherein the beam generator comprises an upper beam limiter configured to generate sub-beams and beam shaping limiter more proximate to the sample position than the upper beam limiter, the beam shaping limiter configured to shape the sub-beams generated by the upper beam limiter.

Paragraph 21. A calibration method comprising: dividing a beam of charged particles from a charged particle source into a plurality of sub-beams or generating a plurality of sub-beams from a beam of charged particles from a charged particle source; projecting the plurality of charged-particle beams toward a calibration object; and detecting returning electrons using a detector module and obtaining an alignment calibration value therefrom.

Paragraph 22. A calibration method according to paragraph 21 further comprising positioning a charged particle mirror downbeam of the objective lens array to reflect charged particles directed toward the sample position back toward the detector module.

Paragraph 23. A calibration method according to paragraph 22, wherein the charged particle mirror comprises a potential source connected to an object located downbeam of the objective lens array to set the object at a predetermined potential relative to the charged-particle source.

Paragraph 24. A calibration method according to paragraph 23, wherein the predetermined potential is in the range of from about -1 V to about -100 V.

Paragraph 25. A calibration method according to paragraph 23 or 24, wherein the object is a sample holder or is held by a sample holder.

Paragraph 26. A calibration method according to paragraph 21 or 22, further comprising holding a calibration target at the sample position, wherein the calibration target is arranged to emit secondary electrons toward the detector module returning electrons.

Paragraph 27. A calibration method according to paragraph 27, wherein the calibration target is comprised in the sample holder or the calibration target is supported by the sample holder.

Paragraph 28. A calibration method according to any one of paragraphs 23 to 27 wherein the object or the calibration target is held so a surface thereof is angled with respect to the plane of the of the objective lens array.

Paragraph 29. A calibration method according to any one of paragraphs 21 to 28 further comprising determining a setting value for a parameter of a corrector, e.g. a deflector, based on the alignment correction value.

Paragraph 30. A calibration method according to paragraph 29, further comprising varying the parameter of the corrector and determining as the setting value the value of the parameter that maximizes the signal e.g. the current, of charged particles that propagate upbeam from the direction of the sample position.

Paragraph 31. An inspection method using an inspection tool comprising: generating a plurality of sub-beams from a beam of charged particles from a charged particle source; projecting the plurality of sub-beams onto a sample; and detecting secondary electrons using a detector module and obtaining information regarding a property of the sample therefrom; wherein a controllable parameter of the inspection tool is set using a calibration value derived by the method of any one of paragraphs 21 to 30.

Paragraph 32. A charged-particle tool comprising: a charged-particle source configured to generate a beam of charged particles; a controller configured to operate the tool in a calibration mode; and an electron optical column configured to generate a plurality of sub-beams from the beam of charged particles and direct the sub-beams downbeam toward a sample position, the column comprising an objective lens arrangement comprising a beam generator to generate the plurality of sub-beams, a beam shaper configured to define from incoming sub-beams the sub-beams that are projected towards the sample position, and a detector module configured to generate a detection signal in response to incidental charged particles that propagate upbeam from the direction of the sample position, the beam generator and the beam shaper having pre-defined alignment; and wherein the detection signal contains information about alignment of the charged-particle source with respect the pre-aligned beam generator and beam shaper.

Paragraph 33. A charged-particle tool comprising: a charged-particle source configured to generate a beam of charged particles; an electron optical column configured to separate the beam of charged particles into a plurality of sub-beams and direct the sub-beams downbeam toward a sample position; wherein the electron optical column includes a beam divider, at least one further electron-optical component and a detector module configured to generate a detection signal in response to returning charged particles that propagate upbeam from the direction of the sample position; and wherein the tool further comprises a controller configured to operate the tool in an inspection mode wherein the detection signal contains information about a property of a sample at the sample position and a calibration mode wherein the detection signal contains information about alignment of at least two of: the charged-particle source; the beam divider; and the or a further electron optical component.

Paragraph 34. A charged-particle tool comprising: a charged-particle source configured to generate a beam of charged particles; an electron optical column configured to generate a plurality of sub-beams from the beam of charged particles and direct the sub-beams downbeam toward a sample position; wherein the electron optical column includes a beam generator at least one further electron-optical component and a detector module configured to generate a detection signal in response to charged particles that propagate upbeam from the direction of the sample position; and wherein the tool further comprises a controller configured to operate the tool in a calibration mode wherein the detection signal contains information about alignment of at least two of: the charged-particle source; the beam generator; and the further electron optical component; or at least two of the further electron-optical components.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A charged-particle tool configured to generate a plurality of sub-beams from a beam of charged particles and direct the sub-beams downbeam toward a sample position, the tool charged-particle tool comprising;

   at least three charged-particle-optical components;
   a detector module configured to generate a detection signal in response to charged particles that propagate upbeam from the direction of the sample position; and
   a controller configured to operate the tool in a calibration mode; wherein:

   the charged-particle-optical components include: a charged-particle source configured to emit a beam of charged particles and a beam generator configured to generate the sub-beams; and

the detection signal contains information about alignment of at least two of the charged-particle-optical components.

2. A tool according to claim 1, wherein the controller is configured to operate the tool in an inspection mode wherein the detection signal contains information about a property of a sample at the sample position.

3. A tool according to claim 1 or 2, further comprising a charged particle mirror located downbeam of the objective lens array and operative to reflect charged particles directed toward the sample position back toward the detector module during the calibration mode.

4. A tool according to claim 3, wherein the charged particle mirror comprises a potential source configured in the calibration mode to set an object located downbeam of the objective lens array at a predetermined potential relative to the charged-particle source.

5. A tool according to claim 4, wherein the tool further comprises a sample holder and the object is the sample holder or is held by the sample holder.

6. A tool according to claim 1 or 2, further comprising a sample holder configured to hold a calibration target at the sample position during the alignment mode, wherein the calibration target is arranged to emit secondary electrons toward the detector module as the charged particles that propagate upbeam from the direction of the sample position.

7. A tool according to claim 6, wherein the calibration target is comprised in the sample holder or the calibration target is supported by the sample holder.

8. A tool according to any one of claims 5 to 7 wherein the controller is configured to control a positioning system to position the object or the calibration target so a surface thereof is tilted with respect to the plane of the of the objective lens array.

9. A tool according to any one of the preceding claims further comprising a corrector, e.g. a deflector, wherein the controller is configured to determine, in the calibration mode, a setting value for a parameter of the corrector to be used in the inspection mode.

10. A tool according to claim 9, wherein the controller is configured, in the calibration mode, to vary the parameter of the corrector and to determine as the setting value the value of the parameter that maximizes the signal e.g. the current, of charged particles that propagate upbeam from the direction of the sample position.

11. A tool according to claim 9 or 10, wherein the corrector comprises at least one of: an array of individual beam correctors configured to correct each sub-beam; a strip corrector configured to operate on the sub-beams; and a corrector configured to operate on the source beam.

12. A tool according to any one of the proceeding claims wherein the detector module is a most downbeam component of the electron optical column.

13. A tool according to any one of claims 1 to 12, wherein the detector module is located upbeam of the most downbeam electron optical component of the electron-optical column.

14. A tool according to any one of the preceding claims wherein the beam generator is a beam-limiting aperture array.

15. A calibration method comprising:

generating a plurality of sub-beams from a beam of charged particles from a charged particle source;
projecting the plurality of charged-particle beams toward a calibration object; and
detecting returning electrons using a detector module and obtaining an alignment calibration value therefrom.

# Fig. 1

# Fig. 2

40

209

202

230

240

211, 212, 213

208

207

201

221, 222, 223

# Fig. 3

EP 4 009 349 A1

# Fig. 4

100μm     50μm

401 { 

5 kV

few kV

402 —— 

5 kV– 10 to 100V

208 —— 

5 kV

406

# Fig. 5

402

404
405
406

# Fig. 6

406

# Fig. 7

408
409
404
407
405

406

24

Fig. 8

Fig. 9

# Fig. 10

# Fig. 11

## Fig. 12

## Fig. 13

## Fig. 14

## Fig. 15

EP 4 009 349 A1

# Fig. 16

# Fig. 17

## Fig. 18

## Fig. 19

# Fig. 20

Europäisches
Patentamt

European
Patent Office

Office européen
des brevets

# EUROPEAN SEARCH REPORT

Application Number

EP 20 21 1715

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/119026 A1 (SOHDA YASUNARI [JP] ET AL) 24 June 2004 (2004-06-24)<br><br>* abstract *<br>* paragraphs [0001], [0016] - [0019], [0027] - [0059]; claims 1,8,14,15; figures 1,2,6 *<br>----- | 1,6,7,9, 11,12, 14,15 | INV.<br>H01J37/304 |
| X | US 2020/124546 A1 (HU XUERANG [US] ET AL) 23 April 2020 (2020-04-23)<br><br>* abstract *<br>* paragraphs [0028] - [0088], [0116], [0126]; figures 1B,3A-6C,7 *<br>----- | 1,2,6,7, 9,11, 13-15 | |
| A | US 2012/305798 A1 (ZONNEVYLLE AERNOUT CHRISTIAAN [NL] ET AL) 6 December 2012 (2012-12-06)<br>* abstract *<br>* figure 1 *<br>----- | 1,15 | |

TECHNICAL FIELDS
SEARCHED       (IPC)

H01J

~~The present search report has been drawn up for all claims~~

| Place of search | Date of completion of the search | Examiner |
|---|---|---|
| Munich | 23 April 2021 | Lang, Thomas |

EPO FORM 1503 03.82 (P04C01)

Europäisches
Patentamt
European
Patent Office
Office européen
des brevets

Application Number

EP 20 21 1715

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1, 2, 6, 7, 9, 12-15(completely); 11(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 20 21 1715

The Search Division considers that the present European patent application does not comply with the requirements of unity of invention and relates to several inventions or groups of inventions, namely:

1. claims: 1, 2, 6, 7, 9, 12-15(completely); 11(partially)

A charged-particle tool configured to generate a plurality of sub-beams from a beam of charged particles and direct the sub-beams downbeam toward a sample position, the charged-particle tool comprising;
at least three charged-particle-optical components;
a detector module configured to generate a detection signal in response to charged particles that propagate upbeam from the direction of the sample position; and
a controller configured to operate the tool in a calibration mode; wherein:
the charged-particle-optical components include: a charged-particle source configured to emit a beam of charged particles and a beam generator configured to generate the sub-beams; and
the detection signal contains information about alignment of at least two of the charged-particle-optical components (claim 1),
wherein the controller is configured to operate the tool in an inspection mode wherein the detection signal contains information about a property of a sample at the sample position (claim 2).

---

2. claims: 3-5(completely); 8(partially)

A tool according to claim 1, further comprising a charged particle mirror located downbeam of the objective lens array and operative to reflect charged particles directed toward the sample position back toward the detector module during the calibration mode.

---

3. claim: 8(partially)

A tool according to claim 1, further comprising a sample holder configured to hold a calibration target at the sample position during the alignment mode, wherein the calibration target is arranged to emit secondary electrons toward the detector module as the charged particles that propagate upbeam from the direction of the sample position (claim 6), wherein the controller is configured to control a positioning system to position the object or the calibration target so a surface thereof is tilted with respect to the plane of the of the objective lens array (claim 8 when dependent on claim 6).

---

4. claim: 10

Europäisches
Patentamt

European
Patent Office

Office européen
des brevets

**LACK OF UNITY OF INVENTION
SHEET B**

Application Number

EP 20 21 1715

The Search Division considers that the present European patent application does not comply with the requirements of unity of invention and relates to several inventions or groups of inventions, namely:

A tool according to claim 1 further comprising a corrector, e.g. a deflector, wherein the controller is configured to determine, in the calibration mode, a setting value for a parameter of the corrector to be used in an inspection mode (claim 9), wherein the controller is configured, in the calibration mode, to vary the parameter of the corrector and to determine as the setting value the value of the parameter that maximizes the signal e.g. the current, of charged particles that propagate upbeam from the direction of the sample position.

---

5. claim: 11(partially)

A tool according to claim 9, wherein the corrector comprises an array of individual beam correctors configured to correct each sub-beam (claim 11, first alternative).

---

6. claim: 11(partially)

A tool according to claim 9, wherein the corrector comprises a strip corrector configured to operate on the sub-beams (claim 11, second alternative).

---

page 2 of 2

## ANNEX TO THE EUROPEAN SEARCH REPORT
## ON EUROPEAN PATENT APPLICATION NO.

EP 20 21 1715

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2021

| Patent document cited in search report | | Publication date | Patent family member(s) | | Publication date |
|---|---|---|---|---|---|
| US 2004119026 | A1 | 24-06-2004 | EP | 1432009 A2 | 23-06-2004 |
| | | | JP | 4365579 B2 | 18-11-2009 |
| | | | JP | 2004200565 A | 15-07-2004 |
| | | | US | 2004119026 A1 | 24-06-2004 |
| US 2020124546 | A1 | 23-04-2020 | CN | 112889127 A | 01-06-2021 |
| | | | EP | 3867942 A1 | 25-08-2021 |
| | | | KR | 20210059764 A | 25-05-2021 |
| | | | TW | 202024769 A | 01-07-2020 |
| | | | US | 2020124546 A1 | 23-04-2020 |
| | | | WO | 2020078660 A1 | 23-04-2020 |
| US 2012305798 | A1 | 06-12-2012 | CN | 103650097 A | 19-03-2014 |
| | | | EP | 2715768 A2 | 09-04-2014 |
| | | | EP | 3660883 A2 | 03-06-2020 |
| | | | JP | 6141276 B2 | 07-06-2017 |
| | | | JP | 2014519724 A | 14-08-2014 |
| | | | KR | 20140048144 A | 23-04-2014 |
| | | | KR | 20180033604 A | 03-04-2018 |
| | | | KR | 20190108187 A | 23-09-2019 |
| | | | KR | 20200023533 A | 04-03-2020 |
| | | | KR | 20200091490 A | 30-07-2020 |
| | | | NL | 2006868 C2 | 03-12-2012 |
| | | | RU | 2013157921 A | 10-07-2015 |
| | | | TW | 201250757 A | 16-12-2012 |
| | | | US | 2012305798 A1 | 06-12-2012 |
| | | | WO | 2012165955 A2 | 06-12-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1602121 A1
- EP 20156253
- EP 20158804 A
- US 20100276606 A
- EP 2702595 A1
- EP 2715768 A2
- EP 2425444 A